# EUROPEAN PATENT APPLICATION

(11) **EP 1 881 537 A1**
(43) Date of publication of application: **23.01.2008**
(21) Application number: 06746073.3
(22) Date of filing: 08.05.2006
(51) Int. Cl.: H01L 33/00, H01L 21/205, H01L 21/338, H01L 29/26, H01L 29/778, H01L 29/812, H01S 5/323

(54) **NITRIDE SEMICONDUCTOR ELEMENT AND PRODUCTION METHOD THEREFOR**

(30) Priority: 09.05.2005 JP 2005136180
(71) Applicant: ROHM CO., LTD., Kyoto-shi, Kyoto 615-8585 (JP)
(72) Inventor: NAKAHARA, Ken, c/o ROHM CO., LTD., Kyoto-shi, Kyoto 6158585 (JP)
(74) Representative: TBK-Patent
(86) International application number: PCT/JP2006/309242
(87) International publication number: WO 2006/121000

(57) **Abstract**

There are provided a nitride semiconductor device having a structure capable of improving crystallinity of grown nitride semiconductor, carrying out easily removing a substrate, and dividing into chips very easily, by using zinc oxide based compound having excellent processability as a substrate, and a method for manufacturing the same. In case that a nitride semiconductor device is formed by laminating nitride semiconductor layers on a substrate (1), the substrate (1) is made of MgₓZn₁₋ₓO (0<x≦0.5), a first nitride semiconductor layer (2) made of In_{y}Ga_{1-y}N (0≦y≦0.5) is provided in contact with the substrate, and nitride semiconductor layers (3) to (7) are laminated on the first nitride semiconductor layer so as to form the semiconductor device.

## Description

### FIELD OF THE INVENTION

The present invention relates to a semiconductor device using nitride semiconductor crystal layers, such as a light emitting device like a light emitting diode (LED), a laser diode or the like, and a transistor device like a HEMT or the like, using nitride semiconductor, and relates to a method for manufacturing the same. More particularly, the present invention relates to a nitride semiconductor device in which nitride semiconductor layers having excellent crystallinity can be grown by making small a difference between lattice constants of a substrate and the nitride semiconductor layers by growing the nitride semiconductor layers on the substrate made of zinc oxide base compound, and the substrate can be easily removed by wet etching even when required to be removed, and relates to a method for manufacturing the same.

### BACKGROUND OF THE INVENTION

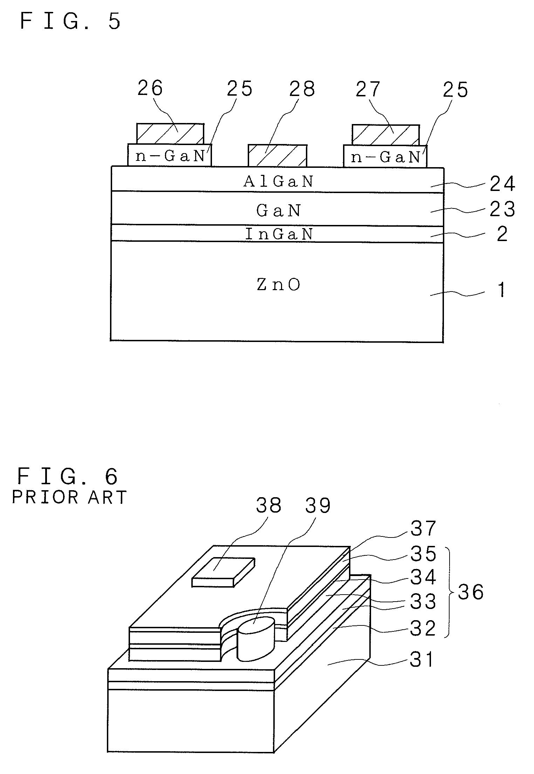

Nitride semiconductor light emitting devices such as a blue light emitting diode (LED), a laser diode or the like, using nitride semiconductor, have been lately in practical use. As shown in Fig. 6, the LED using nitride semiconductor and emitting blue light is formed by forming a semiconductor lamination portion 36 which is formed, for example, on a sapphire substrate 31, by laminating a low temperature buffer layer 32 made of GaN or the like, an n-type layer 33 made of GaN or the like, an active layer (light emitting layer) 34 made of material which has a smaller band gap energy than that of the n-type layer 33 and decides a wavelength of emitted light, for example, an InGaN based (which means that a ratio of In to Ga can be varied variously and the same applies hereinafter) compound semiconductor, and a p-type layer 35 made of GaN or the like, by MOCVD method. And a p-side electrode 38 is formed over a surface thereof interposing a light transmitting conductive layer 37, and an n-side electrode 39 is formed on a surface of the n-type layer 33 exposed by removing a part of the semiconductor lamination portion 36 by etching. Additionally, a semiconductor layer having still larger band gap energy such as an A1GaN based (which means that a ratio of Al to Ga can be varied variously and the same applies hereinafter) compound or the like may be used on an active layer side of the n-type layer 33 and the p-type layer 35 in order to increase an effect of carrier confinement.

In case of laminating the nitride semiconductor layers by MOCVD method, material lattice-mismatched with nitride semiconductor is used in most cases, such that a sapphire substrate or a SiC substrate is used like an example shown in Fig. 6 (cf. for example PATENT DOCUMENT 1). Although a Si substrate may be used besides these, the Si substrate is not suitable for high luminance products having high luminance with being added value, because Si further deteriorates crystallinity of nitride semiconductor layer grown thereon and absorbs emitted light to obstruct improvement of luminance.
PATENT DOCUMENT 1: Japanese Patent Application Laid-Open No. HEI10-256662 (cf. paragraph 0002)

### DISCLOSURE OF THE INVENTION

### PROBLEM TO BE SOLVED BY THE PRESENT INVENTION

As described above, a sapphire substrate or a SiC substrate is used in most cases of growing nitride semiconductor layers. However, the sapphire substrate and the SiC substrate are very hard material and difficult to scribe at the time of dividing a wafer into chips, and at the same time there arises a problem such that a production cost are raised because of decrease of production yield caused by cracks generated when dividing into the chips. And it is preferable to cleave the substrate for forming a reflection surface of a specular surface in case of a laser diode, but especially the sapphire can not be cleaved because it is stable compound.

Further, absorption of light by a substrate is large in case of SiC, and increases especially at wavelengths near 400 nm. Furthermore, when amount of dopant is increased to get contact easily, the absorption of light by the substrate increases more. Thus, since absorption of emitted light by the substrate increases when a wavelength of emitted light is shortened, it is preferable to remove the substrate from the view point of improving external quantum efficiency, and, the substrate is also preferably removed in case of a sapphire substrate, since it is not necessary to remove a part of a semiconductor lamination portion in a mesa shape in order to form an electrode electrically connecting to a lower layer, for example, an n-type layer because electrodes can be formed on both surfaces of the semiconductor lamination portion. However, in order to remove a substrate made of sapphire or SiC from semiconductor layers, there are only ways of removing at an interface after irradiating a laser beam from a substrate side or polishing the substrate. Here, there arise problems in polishing such that productivity is very low because irradiation of the laser beam is carried out on a wafer one by one, and handling is difficult since the wafer bends or makes cracks during polishing because both of the substrates made of sapphire and SiC are lattice-mismatched with nitride semiconductor and have different thermal coefficients.

The present invention is directed to solve the above-described problems and an object of the present invention is to provide a nitride semiconductor device which has a structure capable of improving crystallinity of grown nitride semiconductor, and carrying out easily removing a substrate and dividing into chips very easily, by using zinc oxide based compound, concretely MgₓZn₁₋ₓO (0≦ x≦0.5), having excellent processability as a substrate.

Another object of the present invention is to provide a method for manufacturing a nitride semiconductor device with excellent performance, by using a substrate made of zinc oxide based compound such as MgₓZn₁₋ₓO (0≦x≦ 0.5), and growing nitride semiconductor layers with excellent crystallinity without roughening a surface of the MgₓZn₁₋ₓO substrate by ablation, while the nitride semiconductor layers are epitaxially grown by MOCVD method.

Still another object of the present invention is to provide a semiconductor light emitting device, such as a LED, a semiconductor laser or the like, having a structure capable of easy processing and handling, and improving a light emitting characteristics such as external quantum efficiency or the like, by using such nitride semiconductor, and to provide a method for manufacturing the same.

### MEANS FOR SOLVING THE PROBLEM

The present inventor studied and examined earnestly and repeatedly on a method capable of growing nitride semiconductor layers having excellent crystallinity by using a substrate with excellent handling such as dividing into chips easily or removing the substrate easily. And, as a result, it was found that nitride semiconductor layers with excellent crystallinity can be obtained in which the substrate is prevented from being roughened by erosion of hydrogen, even in subsequent growing of the nitride semiconductor layers by normal MOCVD method, by using a substrate made of zinc oxide based (hereinafter, referred as ZnO based) compound, such as MgₓZn₁₋ₓO (0≦x≦0.5), which is easy to process, and is masked with a back surface and sides thereof so as to expose only a surface on which the semiconductor layers are grown, and growing a nitride semiconductor layer in a nitrogen atmosphere on an exposed portion of the zinc oxide based compound substrate surface, at a temperature raised not so much, at the time of first growing of the nitride semiconductor layers.

Namely, a substrate made of zinc oxide based compound is not used in practical use since nitride semiconductor with excellent crystallinity can not be grown thereon, because the substrate is roughened by ablation of zinc oxide which occurs at a high temperature of 900 °C or more in which nitride semiconductor not including In can be formed with excellent crystallinity in a hydrogen atmosphere in MOCVD method, before nitride semiconductor is grown. However, it was found that, nitride semiconductor layers can be grown on a zinc oxide based compound substrate whose lattice constant is near that of nitride semiconductor by forming a first nitride semiconductor layer on a surface while exposing only a surface on which nitride semiconductor is grown and using nitrogen gas as carrier gas in order not to react with hydrogen at a high temperature, as described above, thereby nitride semiconductor layers very excellent in crystallinity can be grown on the first nitride semiconductor layer even by using normal growing method.

In addition, an lattice constant of ZnO in a surface plane is a=3.252 angstroms and that of GaN a=3.189 angstroms, then the lattice constant of GaN in a surface plane is smaller than that of ZnO by Δ a/a_{ZnO}= 1.937%. However, InGaN based compound has a lattice constant of a-axis direction larger than that of GaN, and it was found that a nitride semiconductor layer lattice matched with the substrate within 1% or less, preferably 0.5%, can be grown, by taking notice that InGaN based compound having same lattice constant as ZnO can be formed by adding a little amount of In since the lattice constant of a-axis direction of InN is large and a=5.76 angstroms. For example, if it is assumed that a lattice constant varies in proportion to In concentration (actually, as a bowing effect based on a distortion exists, a precise lattice constant is hardly obtained by calculation), perfect lattice matching can be obtained with ZnO when the In concentration y of InGaN based compound is y=0.0245, namely In of 2.45% is added, according to an equation a(y)=3.189(1-y)+5.76y=3.252 by Vegard's law. That is, it was found that a nitride semiconductor layer having excellent crystallinity can be obtained by forming firstly a first nitride semiconductor layer lattice matched by containing In having such ratio for lattice matching.

When difference of lattice constants between a first nitride semiconductor layer and a nitride semiconductor layer laminated thereon is large, a gradient layer or a super-lattice structure may be provided between them. However, In concentration of the first nitride semiconductor layer itself may be decreased stepwise or continuously to match with concentration of the nitride semiconductor layer thereof or a super-lattice structure of layers of InGaN based compound layer and layers of concentration of the nitride semiconductor layer thereof such as a GaN layer or the like may be formed. In such manner, nitride semiconductor layers forming a semiconductor device, such as an n-type layer or the like which is lattice matched with the first nitride semiconductor layer, can be grown directly on the first nitride semiconductor layer while alleviating strains.

A nitride semiconductor device according to the present invention includes a substrate made of zinc oxide based compound, a first nitride semiconductor layer made of InyGa_{1-y}N (0<y≦0.5) which is provided in contact with the substrate, and nitride semiconductor layers laminated on the first nitride semiconductor layer so as to form a semiconductor device.

Here, the zinc oxide based compound means an oxide including Zn, concretely besides ZnO, an oxide of any of elements of group II A and zn, of any elements of group IIB and Zn, or of any elements of group IIA and any elements of group IIB and Zn. Further, the nitride semiconductor means a compound of Ga of group III element and N of group V element or a compound (nitride) in which a part or all of Ga of group III element is substituted by other element of group III element like Al, In or the like and/or a part of N of group V element is substituted by other element of group V element like P, As or the like.

A problem of lattice mismatching may be preferably improved further by providing the first nitride semiconductor layer so as to be lattice matched with the substrate in a crystal lattice constant on a surface plane, wherein "to be lattice matched with the substrate" means Δ a/a ≦1%, here Δ a represents an absolute value of difference between lattice constants of a-axis of the substrate and the first nitride semiconductor layer, and 'a' a lattice constant of a-axis of the substrate.

The first nitride semiconductor layer includes layers contained with In and layers not-contained with In which are laminated alternately, and the first nitride semiconductor layer is formed with a super-lattice structure by forming each of layers with a thickness of 50 nm or less, because although perfect lattice matching between a substrate and a first nitride semiconductor layer is not formed, strain is not accumulated by the super-lattice structure, and nonconformity accompanied with lattice mismatching does not occur. In addition, since layers including In are laminated alternately, a growing temperature is required to be low in accordance with that of the layers including In, and, at the same time, carrier gas is required to be nitrogen gas because In is apt to separate in H₂ gas. Thereby, zinc oxide based compound such as MgₓZn₁₋ₓO or the like is not exposed to hydrogen gas of reductive gas spontaneously and the substrate is not roughened. Then, a first nitride semiconductor layer with excellent crystallinity can be grown, and nitride semiconductor layers laminated thereon does not raise a problem of lattice mismatching and can be laminated with excellent crystallinity.

It is preferable that the first nitride semiconductor layer such that In concentration decreases continuously or discontinuously in accordance with being close to a surface side thereof, because a problem of lattice mismatching can be almost resolved, even when a nitride semiconductor layer, in which In concentration is low, such as GaN or the like is formed.

When an n-type layer made of n-Al_{z}Ga_{1-z}N (0≦z≦1) is formed on the first nitride semiconductor layer, and an n-side electrode is formed directly on the n-type layer, for example, in case that a light emitting device is formed, emitted light can be taken out from a substrate side while a pair of electrodes is formed on one surface side and electrodes side is on a bonded surface, same as in a conventional case of using a sapphire substrate. In addition, the substrate can be removed easily even the substrate is required to be removed since zinc oxide based compound such as MgₓZn₁₋ₓO or the like can be removed by wet etching, on the contrary, nitride semiconductor layer can not be removed by wet etching, then, light can be utilized efficiently at the time of forming a light emitting device, or the like.

In case that the substrate and the first nitride semiconductor layer are formed in an n-type conductivity, an n-type layer made of n-Al_{z}Ga_{1-z}N (0≦z≦1) is provided on the first nitride semiconductor layer of the n-type conductivity, and an n-side electrode is formed on an opposite surface of the substrate which is a surface opposed to a surface on which the first nitride semiconductor layer is provided, it is not necessary to expose the n-type layer of a lower layer by etching a part of the semiconductor lamination portion, then a vertical type device is formed and a pair of electrodes can be provided on an upper and a lower sides of a chip. Thereby, an assembly process becomes very easy even when a LED chip is mounted in a recessed part in a bowl shape provided at lead ends, for example, when the semiconductor device is a light emitting device.

Concretely, a semiconductor light emitting device can be formed by laminating an active layer and a p-type layer on the n-type layer so as to form a light emitting layer, and forming a p-side electrode so as to be electrically connected to the p-type layer.

A method for manufacturing a nitride semiconductor device according to the present invention includes the steps of: (a) forming a protection film on an exposed surface of a substrate made of zinc oxide based compound except a surface on which semiconductor layers are laminated; (b) growing a first nitride semiconductor layer made of In_{y}Ga_{1-y}N (0<y≦0.5) by setting the substrate within an MOCVD apparatus and by using nitrogen gas for carrier gas; and (c) growing desired nitride semiconductor layers subsequently, thereby forming a nitride semiconductor device.

It is preferable that the first nitride semiconductor layer is grown at a temperature of 600 to 900 °C which is lower than that for growing GaN, because nitride semiconductor layers can be grown without roughening a MgₓZn₁₋ₓO substrate.

The first nitride semiconductor layer may be grown in a super-lattice structure or in a gradient layer in which In concentration decreases gradually or stepwise, by adjusting a flow rate of raw material gas of In.

It is preferable to remove a part or all of the substrate by wet etching after forming a device in the step (c), since external quantum efficiency is improved because emitted light can be taken out without absorption by a substrate or the like. In this case, if the substrate is made of ZnO, and the first nitride semiconductor layer is grown on a surface of the substrate which has Zn polarity, and a back surface of the substrate which is a surface wet etched has O polarity, productivity is improved because etching is carried out fast.

Concretely, a semiconductor light emitting device may be formed by forming nitride semiconductor layers on the first nitride semiconductor layer so as to form a light emitting layer in which at least an n-type layer and a p-type layer are included, the n-type layer being formed on a surface side of the first nitride semiconductor layer and the p-type layer on a surface side, and forming an n-side electrode on the n-type layer exposed by wet etching. In addition, efficiency of taking out light can be improved in case of forming a LED by forming unevenness on a surface of the n-type layer exposed by wet etching, thereafter forming the n-side electrode.

It may be that the step (c) includes; forming nitride semiconductor layers on the first nitride semiconductor layer so as to form a light emitting layer in which at least an n-type layer and a p-type layer are included, the n-type layer being formed on a surface side of the first nitride semiconductor layer and the p-type layer on a surface side, dividing into chips after forming a p-side electrode at a surface side thereof, and removing a part or all of the substrate by wet etching after die bonding a side of the p-side electrode on a submount. In such manner, since the substrate can be removed after mounting a device, a very thin device can be mounted surely on the submount or the like. The submount may be made of one selected from a group of metal, AlN, SiC and diamond, or a substance which is coated with Cu or Ag on a surface of the one.

### EFFECT OF THE INVENTION

An electrode of one side can be formed at a back surface side of the substrate and the substrate can be easily removed by wet etching in case of removing the substrate, by a nitride semiconductor device according to the present invention, since nitride semiconductor layers are laminated on a substrate made of zinc oxide based compound such as MgₓZn₁₋ₓO or the like. In addition, since the first nitride semiconductor layer which is formed directly on a surface of the substrate is formed with an InyGa_{1-y}N (0<y≦0.5) layer, perfect lattice matching with the substrate can be obtained by adjusting In concentration. Therefor, nitride semiconductor layers with excellent crystallinity can be grown, a nitride semiconductor device with high performance such as a nitride semiconductor light emitting device with excellent light emitting performance.

On the other hand, by a method for manufacturing a nitride semiconductor according to the present invention, since the first nitride semiconductor layer made of InyGa_{1-y}N is grown by masking the substrate made of zinc oxide based compound such as MgₓZn₁₋ₓO or the like except a surface on which semiconductor layers are laminated, and by using nitrogen gas as carrier gas, nitride semiconductor layers with excellent crystallinity can be grown without roughening a substrate by ablation even when gallium nitride based compound is grown by MOCVD method. AS a result, if a LED, a laser diode (LD) or the like is formed, a semiconductor light emitting device with high performance which has high internal quantum efficiency and low threshold current can be obtained, and if a transistor or the like is formed, a transistor (HEMT) with high speed which has small leakage current and high withstand voltage can be obtained.

### BRIEF DESCRIPTION OF THE DRAWINGS

Fig. 1 is an explanatory cross-sectional view of a LED which is an embodiment of a nitride semiconductor device according to the present invention.
Fig. 2 is an explanatory cross-sectional view showing an example of a protection film in case of growing nitride semiconductor layers on the substrate shown in Fig. 1.
Fig. 3 is a figure showing examples of structures of a first nitride semiconductor layer formed on a substrate by the present invention.
Fig. 4 is an explanatory cross-sectional view showing another constitution example of the nitride semiconductor light emitting device according to the present invention.
Fig. 5 is an explanatory cross-sectional view of a constitution of a transistor which is formed by the present invention.
Fig. 6 is an explanatory cross-sectional view of a constitution of a LED using conventional nitride semiconductor.

### EXPLANATION OF LTTERS AND NUMERALS

- 1:: substrate
- 2:: first nitride semiconductor layer
- 3:: n-type layer
- 4:: active layer
- 5:: p-type layer
- 6:: semiconductor lamination portion
- 7:: light transmitting conductive layer
- 8:: p-side electrode
- 9:: n-side electrode

### THE BEST EMBODIMENT OF THE PRESENT INVENTION

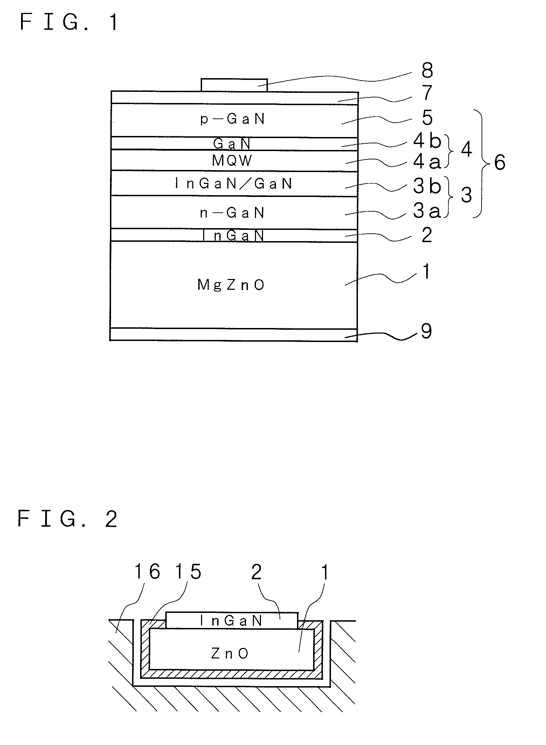

An explanation will be given below of a nitride semiconductor device according to the present invention and a method for manufacturing the same in reference to the drawings. As an explanatory cross-sectional view of a nitride semiconductor light emitting device (LED chip) which is an embodiment of the present invention is shown in Fig. 1, the nitride semiconductor device according to the present invention is formed such that, in case that a nitride semiconductor device is formed by laminating nitride semiconductor layers on a substrate 1, the substrate 1 is made of zinc oxide based compound such as MgₓZn₁₋ₓO (0≦x≦0.5), a first nitride semiconductor layer 2 made of In_{y}Ga_{1-y}N (0≦y≦0.5) is provided in contact with the substrate, and nitride semiconductor layers 3 to 7 are laminated on the first nitride semiconductor layer 2 so as to form the semiconductor device (so as to form a light emitting layer of a LED in the example shown in Fig. 1).

Namely, the present invention is characterized in using a substrate made of zinc oxide based compound such as MgₓZn₁₋ₓO or the like as the substrate 1, and providing an InyGa_{1-y}N layer directly on a surface of the substrate as the first nitride semiconductor layer 2, in order to laminate nitride semiconductor layers by MOCVD method. Nitride semiconductor grown at a high temperature has an excellent layer property when nitride semiconductor layers are grown by MOCVD method as described above, however, if it is grown at a temperature of approximately 900 to 1100 °C under an atmosphere of hydrogen, semiconductor layers with excellent property can not be grown because zinc oxide is ablated and unevenness occurs on a surface of the substrate on which epitaxial growth is carried out. Then, Zno based compound such as MgₓZn₁₋ₓO has not been used for a substrate. But, the present inventor discovered, as a result of earnest and repeated study and examination, that nitride semiconductor layers with excellent crystallinity in which the substrate made of ZnO based compound is not roughened can be grown by coating the substrate with a protection film while exposing a surface on which epitaxial growth is carried out, carrying out cleaning or the like of the substrate 1 in a nitrogen atmosphere so as not to expose to oxygen, growing by using nitrogen gas as carrier gas and at a temperature of 800 °C or less when the first nitride semiconductor layer 2 is formed firstly. Further, it is preferable that a layer contained with In or a super-lattice structure by laminating a layer contained with In and a GaN layer alternately, as the first nitride semiconductor layer 2 is formed.

Whole semiconductor layers can be grown as the semiconductor layers with excellent crystallinity since the substrate is not roughened and unevenness does not occur by forming the first nitride semiconductor layer 2 in a thickness of approximately 10 nm or more, because the substrate is coated with the protection film except a growth surface even if a later growth of nitride semiconductor layers are carried out by using a growth process similar to a conventional one, and since the nitride semiconductor layers are grown on the first nitride semiconductor layer 2 having a lattice constant near that of the substrate.

A substrate 1 made of ZnO based compound such as MgₓZn₁₋ₓO or the like, for example ZnO, is used as the substrate 1. By using such oxide, the substrate can be removed easily by wet etching, an electrode of one side can be extracted from a back surface of the substrate since semiconductor is conductive, and, above all, perfect lattice matching with the substrate can be obtained by adding suitable amount of In to the nitride semiconductor since the lattice constant is near that of the nitride semiconductor and easy to be lattice matched. In addition, the substrate 1 is not need to be made of ZnO, and MgₓZn₁₋ₓO mixed with Mg may be used in order not to absorb light in case of a short wavelength of emitted light when a light emitting device is formed.

If the substrate 1 is exposed to a hydrogen atmosphere at a high temperature, ZnO is ablated from an exposed surface as described above, unevenness occurs on a surface, crystallinity of the substrate itself deteriorates, crystallinity of semiconductor layers grown thereon deteriorates remarkably. Then, as shown in Fig. 2, nitride semiconductor layers grown after protecting a back surface and surfaces from a side to a peripheral portion of the surface of the ZnO substrate 1 by coating with a protection film 15 made of SiO, SiN, Pt or the like, which does not evaporate at a high temperature, and setting the ZnO substrate 1 (wafer) on a work carrier 16 of a MOCVD apparatus, made of carbon, molybdenum or the like.

Although the first nitride semiconductor layer 2 is provided to cover a surface in order not to roughen the surface of the ZnO substrate 1 and, at the same time, to lattice match with the ZnO substrate 1, it is the primary object to inhibit ablation of the ZnO substrate 1, and the secondary object to lattice match perfectly because lattice mismatching between the ZnO substrate 1 and the nitride semiconductor layer is not so large as that between a sapphire substrate and the nitride semiconductor layer. As described above, when nitride semiconductor layers are grown using the ZnO substrate 1 by MOCVD method, the ZnO substrate 1 ablates at a temperature of 900 °C or more which is a temperature for growing the nitride semiconductor layers, and a surface is roughened, then, the nitride semiconductor layers with excellent crystallinity can not be obtained. However, it is rather preferable to lower a growth temperature to 900 °C or less for growing InGaN based compound, and there is a property such that growth by using hydrogen gas as carrier gas is difficult and that by using nitrogen gas is easy, therefore, InGaN based compound is firstly grown on the ZnO substrate 1. In such manner, a surface of the ZnO substrate 1 is not roughened and nitride semiconductor layers with excellent crystallinity can be obtained by growing a nitride semiconductor layer made of InGaN based compound at a temperature of 900 °C or less and in an atmosphere of nitrogen gas. In addition, the first nitride semiconductor layer should be matched in a conductivity type with that of the substrate 1 in case of forming an electrode of one side on a back surface of the substrate, however, the first nitride semiconductor layer undoped or doped with Si (n-dopant) or the like may be used in case of not forming the electrode on the back surface of the substrate 1.

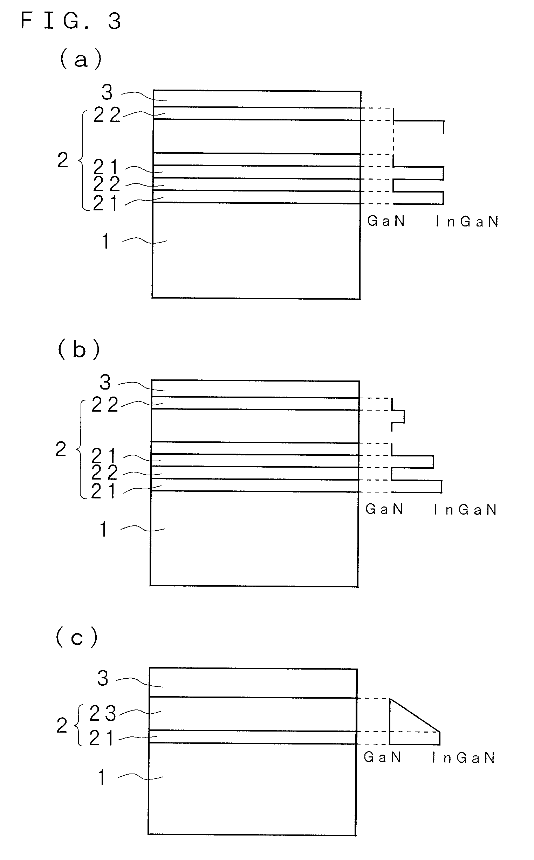

On the other hand, the first nitride semiconductor layer 2 is not always a layer contained with In, as shown in Fig. 3(a) for example, a super-lattice structure may be formed by laminating an InGaN based compound layer 21 and a GaN layer 22 alternately, each of which has a thickness of 50 nm or less, for example 5 nm (a profile of concentration variation of the GaN and the InGaN is shown at right side of the cross-sectional view). In this case, it is more preferable that as a similar explanatory figure is shown in Fig. 3(b), In concentration of the InGaN based compound layer 21 is closed to that of the n-type layer 3 by decreasing with being close to a surface side.

However, the first nitride semiconductor layer 2 is preferable, because of enabling the lattice constant in a surface plane to match with that of the substrate 1 perfectly by adjusting In concentration, and growing nitride semiconductor layers with excellent crystallinity by lattice matching between the nitride semiconductor layers and the substrate made of different material. If the first nitride semiconductor layer 2 with excellent crystallinity is grown by attempting to lattice match with substrate 1, nitride semiconductor layers laminated thereon can be grown with excellent crystallinity, because the nitride semiconductor layers are made of nitride semiconductor of the same kinds even if their lattice constants are different somewhat, depending on material concentration. However, the crystallinity can be further improved by laminating the nitride semiconductor layers interposing a super-lattice structure, a gradient layer or the like between them. In this case, as shown in Fig. 1, a super-lattice structure or a gradient layer may be provided between the first nitride semiconductor layer 2 and the n-type layer 3 in order to cancel lattice-mismatching caused by difference of both concentration, or the first nitride semiconductor layer 2 itself may be formed with the super lattice-structure as shown in Fig. 3(a) or (b) or the first nitride semiconductor layer 2 may be formed with the gradient layer 23 as shown in Fig. 3(c).

Namely, as shown in Fig. 3(c), the first nitride semiconductor layer is formed such that an InGaN based compound layer 21 lattice matched with a ZnO substrate 1 is provided in a first depth of approximately 10 nm, and In concentration thereabove is decreased gradually so as to form finally a GaN layer matched with the n-type layer 3 in concentration. A total thickness including the gradient layer has no limitation, but it is preferable to be 1 µm or less. As for this example, a profile of concentration variations of GaN and InGaN are shown at a right side of the cross-sectional view. Concentration of the gradient layer may be varied continuously or stepwise as in an example shown in Fig. 3(c). Such concentration variation can be obtained, for example, by decreasing a flow rate of trimethyl indium (TMIn) which is raw gas of In continuously or stepwise during growing the first nitride semiconductor layer by MOCVD method.

Other portion of the semiconductor lamination portion 6 is formed by laminating the n-type layer 3 of a thickness of approximately 1 to 10 µm composed of a contact layer 3a made of GaN doped with Si and a super-lattice layer 3b made of InGaN-based-compound/GaN, an active layer 4 of a thickness of approximately 0.05 to 0.3 µm in total, composed of a MQW layer 4a made of undoped InGaN-based-compound/GaN (for example, a structure of a multiple quantum well formed by laminating 3 to 8 pairs of a well layer made of In_{0.17}Ga_{0.83}N and having a thickness of 1 to 3 nm, and a barrier layer made of In_{0.01}Ga_{0.99}N and having a thickness of 10 to 20 nm) and an undoped GaN layer 4b, and a p-type layer 5 made of GaN doped with Mg of a thickness of approximately 0.2 to 1 µm.

In addition, the semiconductor lamination portion 6 is laminated with a necessary constitution depending on a semiconductor device manufactured, then it is not limited to the above-described example in case of LED, and the n-type layer 3 and the p-type layer 5 may be formed in a multilayer structure in which a layer (barrier layer) having a large band gap energy is provided at an active layer side, a super-lattice structure or a gradient layer may be provided between semiconductor layers having different composition, and the super-lattice layer 3b or the undoped GaN layer 4b maybe omitted by contraries. Although, the above-described example is a double hetero junction structure in which the active layer 4 is sandwiched by the n-type layer 3 and the p-type layer 5, a structure of a hetero junction structure may be used in which the n-type layer and the p-type layer are directly joined. The point is that an n-type layer 3 and a p-type layer 5 are provided so as to form a light emitting layer in case of constituting LED. And, although the above-described example is an example of a LED, a laser diode can be formed by forming a light emitting region of a stripe shape in a similar manner.

An explanation of a method for manufacturing the nitride semiconductor light emitting device shown in Fig. 1 will be given below. Firstly, a wafer in which the protection film is formed on a surface of the ZnO substrate 1 formed in an n-type conductivity, except a growth surface as shown in Fig. 2 is set within a MOCVD apparatus and a surface of the substrate is cleaned in nitrogen carrier gas and at a raised temperature of approximately 700 to 900 °C. At this time, it is necessary to notice that ZnO ablates and unevenness occurs on an epitaxially grown surface if cleaning of the substrate is carried out at a temperature of 1000 °C or more which is for a sapphire substrate or the like.

Subsequently, after lowering a temperature to approximately 800 °C while the carrier gas is still nitrogen gas, the first nitride semiconductor layer 2 made of, for example, InGaN based compound which is lattice matched with the substrate 1 is formed in a thickness of approximately 10 to 100 nm, by doping Si. The doping of Si is necessary in order to form an electrode on a back surface of the substrate 1, however, an undoped layer may be used when the electrode is not formed on the back surface of the substrate 1. Thereafter, a contact layer 3a made of GaN doped with Si is formed by changing the carrier gas to hydrogen gas and, at the sane time, by raising a temperature of the substrate to a high temperature of approximately 900 to 1200 °C, for example approximately 1000 °C, and a super-lattice layer 3b made of InGaN-based-compound/GaN is grown by lowering the temperature to 600 to 800 °C, thereby an n-type layer 3 is laminated in a thickness of approximately 1 to 10 µm. The super-lattice layer 3b is provided in order to inhibit applying a lattice strain to the active layer 4 in which excellent crystallinity is required.

Subsequently, the active layer 4 is laminated in a thickness of 0.05 to 0.3 µm which is constituted of the MQW layer 4a formed by laminating approximately 3 to 8 pairs of the well layer made of undoped In_{0.17}Ga_{0.83}N and having a thickness of, for example, approximately 1 to 3 nm, and the barrier layer made of GaN and having a thickness of, for example, approximately 10 to 20 nm, alternately, and the undoped GaN layer 4b. These may be doped with Si of approximately 1×10¹⁷ to 1×10¹⁸ cm⁻³. Then the semiconductor lamination portion 6 is formed by growing the p-type layer 5 made of GaN doped with Mg is grown in a thickness of approximately 0.2 to 1 µm after raising a temperature within a growth furnace to approximately 900 to 1200 °C, for example approximately 1000 °C.

At the time of forming each layer of the above-described semiconductor layers from the n-type layer 3, a semiconductor layer with a desired composition, a desired conductivity type and a desired thickness can be formed by supplying necessary gasses, with H₂ for a carrier gas, such as a reactant gas like trimethyl gallium (TMG), ammonia (NH₃), trimethyl aluminum (TMA), trimethyl indium (TMIn) or the like, and a dopant gas like SiH₄ for making an n-type, or a dopant gas like biscyclopentadienyl magnesium (Cp₂Mg). In addition, In concentration of InGaN based compound can be varied by adjusting a flow rate of TMIn which is raw material gas of In.

Then, a light transmitting conductive layer 7 made of, for example, ZnO or the like, and able to make ohmic contact with a p-type semiconductor layer 5 is formed in a thickness of 0.01 to 5 µm on a surface of the semiconductor lamination portion 6. The ZnO layer is formed such that a specific resistance is approximately 3×10⁻⁴ to 5×10⁻⁴ Q cm. As the light transmitting conductive layer 7 is not limited to ZnO, ITO or a thin alloy layer of Ni and Au having a thickness of approximately 2 to 100 nm can be used and diffuse electric current to whole part of a chip while transmitting light.

Then, after a back surface of the substrate 1 is polished so that a thickness of the substrate 1 is approximately 100 µm, the n-side electrode 9 is formed by laminating Ti/Au, Cr/Pt/Au or the like on the back surface and sintering. And the p-side electrode 8 is formed in a lamination structure made of Ti/Au by a lift off method on a surface of the light transmitting conductive layer 7, and, finally, an opening portion is formed at an electrode portion by coating whole of a chip with SiON film not shown in the figure by plasma CVD method. Thereafter, a light emitting device chip shown in Fig. 1 is formed by dividing a wafer into chips. In addition, at the time of dividing into chips, border portions of chips of the semiconductor lamination portion 6 are etched beforehand in a mesa shape by dry etching. The n-side electrode 9 may be formed on a surface of the n-type layer 3 exposed by etching a part of the semiconductor lamination portion 6 instead of forming on the back surface of the substrate 1.

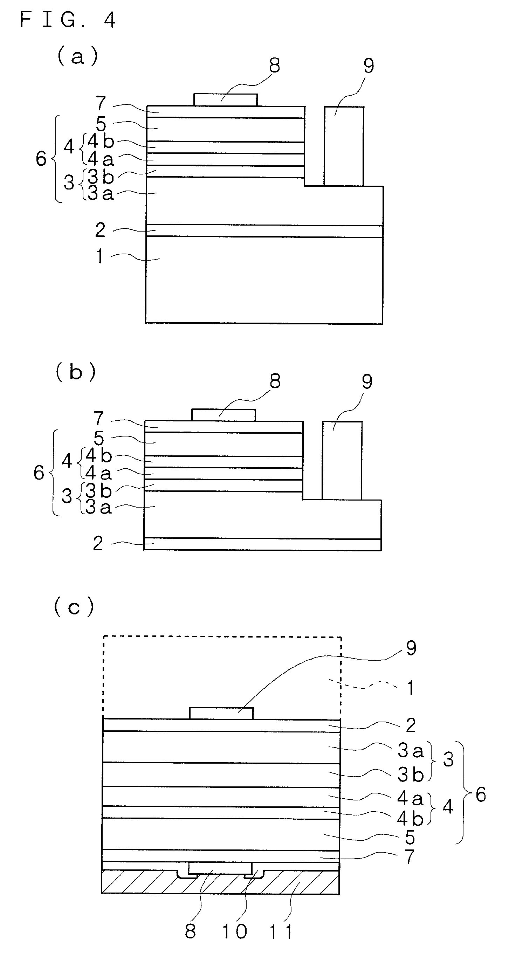

According to the present invention, since nitride semiconductor layers are laminated on a ZnO based compound substrate, one electrode is formed on a back surface of the substrate and a vertical type device can be obtained in which a pair of electrodes can be provided on an upper and a lower parts of a chip. However, even in case of using such semiconductor substrate, the n-side electrode 9 can be formed on the n-type layer 3 exposed by etching a part of the semiconductor lamination portion 6 laminated by dry etching, as shown in Fig. 4(a). In addition, a structure of the semiconductor lamination portion or the like is same as that of an example shown in Fig. 1, the same letters and numerals are attached to the same parts, and an explanation is omitted. A flip-chip structure may be formed in which a pair of electrodes can be connected directly to a mounting board or the like by setting the upper surface of a chip down and by soldering or the like.

Furthermore, according to the present invention, since a ZnO based compound substrate is used in case of forming such structure, the substrate can be removed easily by wet etching using HCl or the like as shown in Fig. 4(b). Namely, since a nitride semiconductor layer can not be etched by wet etching, the substrate can be removed easily by carrying out wet etching by masking a surface side of an electrode portion or the like, and external quantum efficiency can be improved by removing such substrate even if emitted light has a short wavelength and is absorbed by the substrate. As other structure such as a semiconductor lamination portion 6 of the example is also same as that of an example shown in Fig. 1, the same letters and numerals are attached to the same parts and an explanation is omitted. In addition, when InGaN based compound is grown on a Zn polarity surface of ZnO such that nitride semiconductor layers are grown in a direction of Zn polarity of a ZnO substrate and a surface wet etched has O polarity, productivity is improved because etching is carried out fast.

Such structure for removing the substrate may be used for forming the electrode of one side on the nitride semiconductor layer exposed by removing the substrate besides for forming both electrodes on one side. Namely, after forming the p-side electrode 8 in a state of a wafer in a structure shown in Fig. 1, a miller structure may be formed by forming an insulating film 10 made of SiO, SiN, Al₂O₃ or the like on whole surface, exposing a part over the p-side electrode 8 by opening the part, and forming a laminated metal film 11 made of Ag/Ti/Pt/Au on the whole surface. Only the ZnO substrate 1 can be removed by dipping the wafer in this state in HCl solution without etching the metal film and nitride semiconductor layers. The n-side electrode 9 is formed on the exposed surface thereof and the light can be taken out from an exposed surface side. In this case, the exposed n-type layer may be the first nitride semiconductor layer or the n-type layer 3 grown thereon. Also, a left part of the ZnO substrate 1 formed with an n-type conductivity may be used as the exposed n-type layer. The metal film 11 described above can be directly bonded to a die-bonding substrate or the like with an Au-Sn alloy or the like.

In case of mounting a chip with a face-down structure as in a semiconductor laser to a submount or the like with high thermal conductivity, the substrate can be removed by dividing into chips after forming a p-side electrode in a state of a wafer, and etching by using the above described etchant after bonding a p-side electrode side to a surface of the submount. In such manner, damage or the like during handling never occurs, and a device of a very thin type can be mounted. Emitted light can be utilized very effectively in a LED by using such constitution. The submount with high thermal conductivity may be made of one selected from a group of metal, AlN, SiC and diamond, or a substance which is coated with Cu or Ag on a surface of the one.

Furthermore, when the above described n-type layer is exposed and the n-side electrode is formed on the exposed surface thereof, it is preferable that unevenness is formed on the exposed surface by etching, because efficiency of taking out light is improved. At this time of forming unevenness on a nitride semiconductor layer, the unevenness is normally formed by dry etching or mechanical sand blast, however the unevenness can be formed by leaving a part of a ZnO substrate by wet etching.

Fig. 5 is a cross-sectional view explaining a transistor constituted by laminating nitride semiconductor layers with excellent crystallinity by forming a first nitride semiconductor layer 2 made of InGaN based compound on a surface of the above described ZnO base compound substrate 1. In the same manner as that of the light emitting device, a first nitride semiconductor layer 2 is firstly grown at a low temperature of 800 °C or less by supplying nitrogen gas as carrier gas within MOCVD apparatus, and subsequently there are grown in order by supplying necessary organic metal gasses in the same manner as described above, an undoped GaN layer 23 approximately 4 µm thick, an electron transit layer 24 approximately 10 nm thick made of undoped AlGaN based compound, and an n-type GaN layer 25 approximately 5 nm thick. Thereafter, the electron transit layer 24 is exposed by removing a part of the n-type GaN layer 25 by etching so as to provide a predetermined distance of approximately 1.5µm to be a gate length. And a transistor is constituted by forming a source electrode 26 and a drain electrode 27 made of, for example, a Ti film and an Au film on the n-type GaN layer 25 left having a predetermined distance, and by forming a gate electrode 28 formed by laminating, for example, a Pt film and an Au film, on a surface of the undoped AlGaN based compound layer 24. The nitride semiconductor layers with excellent crystallinity can be formed by forming a buffer layer 2 made of single crystal on such substrate, and growing GaN layers thereon, and a transistor (HEMT) of a small leakage current and high break down voltage can be obtained.

As described above, when nitride semiconductor layers are laminated while a substrate is made of ZnO based compound such as ZnO, a nitride semiconductor device with excellent crystallinity can be formed according to the present invention since a first nitride semiconductor layer made of InGaN which can be lattice matched with the substrate is formed on a surface of the substrate and nitride semiconductor layers are formed thereon. AS a result, a performance of a device using nitride semiconductor can be remarkably improved such as a nitride semiconductor light emitting device like LED, LD (laser diode), or the like with excellent light emitting characteristics, or a nitride transistor like HEMT or the like with small leakage current and high withstand voltage.

### INDUSTRIAL APPLICABIITY

Characteristics of a light emitting device using nitride semiconductor, such as a LED and laser, and a transistor device such as a HEMT can be improved and the nitride semiconductor device can be used in every kinds of electronic apparatus using the nitride semiconductor device.

## Claims

1. A nitride semiconductor device comprising
a substrate made of zinc oxide based compound,
a first nitride semiconductor layer made of InyGa_{1-y}N (0 < y ≦ 0.5) which is provided in contact with the substrate, and
nitride semiconductor layers laminated on the first nitride semiconductor layer so as to form a semiconductor device.

2. The nitride semiconductor device according to claim 1, wherein the first nitride semiconductor layer is provided so as to be lattice matched with the substrate in a crystal lattice constant on a surface plane, wherein "to be lattice matched with the substrate" means Δa/a≦1%, here Δ a represents an absolute value of difference between lattice constants of a-axis of the substrate and the first nitride semiconductor layer, and 'a' a lattice constant of a-axis of the substrate.

3. The method for manufacturing the nitride semiconductor device according to claim 1 or 2, wherein the first nitride semiconductor layer comprises layers contained with In and layers not-contained with In which are laminated alternately, and the first nitride semiconductor layer is formed with a super-lattice structure by forming each of layers with a thickness of 50 nm or less.

4. The nitride semiconductor device according to claim 1 or 2, wherein the first nitride semiconductor layer is formed such that In concentration decreases continuously or discontinuously in accordance with being close to a surface side thereof.

5. The nitride semiconductor device according to any one of claims 1 to 4, wherein an n-type layer made of n-Al_{z}Ga_{1-z}N (0≦ z ≦ 1) is provided on the first nitride semiconductor layer, and an n-side electrode is formed directly on the n-type layer.

6. The nitride semiconductor device according to any one of claims 1 to 4, wherein the substrate and the first nitride semiconductor layer are formed in an n-type conductivity, an n-type layer made of n-Al_{z}Ga_{1-z}N (0 ≦ z ≦ 1) is provided on the first nitride semiconductor layer of the n-type conductivity, and an n-side electrode is formed on an opposite surface of the substrate which is a surface opposed to a surface on which the first nitride semiconductor layer is provided.

7. The nitride semiconductor device according to claim 5 or 6, wherein a semiconductor light emitting device is formed by laminating an active layer and a p-type layer on the n-type layer so as to form a light emitting layer, and forming a p-side electrode so as to be electrically connected to the p-type layer.

8. A method for manufacturing a nitride semiconductor device comprising the steps of:
(a) forming a protection film on an exposed surface of a substrate made of zinc oxide based compound except a surface on which semiconductor layers are laminated;
(b) growing a first nitride semiconductor layer made of InyGa_{1-y}N (0<y≦0.5) by setting the substrate within an MOCVD apparatus and by using nitrogen gas for carrier gas; and
(c) growing desired nitride semiconductor layers subsequently, thereby forming a nitride semiconductor device.

9. The method for manufacturing a nitride semiconductor device according to claim 8, wherein the first nitride semiconductor layer is grown at a temperature of 600 to 900 °C which is lower than that for growing GaN.

10. The method for manufacturing a nitride semiconductor device according to claim 8 or 9, wherein the first nitride semiconductor layer is grown in a super-lattice structure or in a gradient layer in which In concentration decreases gradually or stepwise, by adjusting a flow rate of raw material gas of In.

11. The method for manufacturing a nitride semiconductor device according to any one of claims 8 to 10, wherein a part or all of the substrate is removed by wet etching after forming a device in the step (c).

12. The method for manufacturing a nitride semiconductor device according to claim 11, wherein the step (c) comprising the following steps, thereby forming a semiconductor light emitting device:
forming nitride semiconductor layers on the first nitride semiconductor layer so as to form a light emitting layer in which at least an n-type layer and a p-type layer are included, the n-type layer being formed on a surface side of the first nitride semiconductor layer and the p-type layer on a surface side; and
forming an n-side electrode on the n-type layer exposed by removing the substrate by wet etching.

13. The method for manufacturing a nitride semiconductor device according to claim 12, wherein unevenness is formed on a surface of the n-type layer exposed by wet etching, thereafter forming the n-side electrode.

14. The method for manufacturing a nitride semiconductor device according to any one of claims 8 to 13, wherein the step (c) comprising the following steps, thereby forming a semiconductor light emitting device:
forming nitride semiconductor layers on the first nitride semiconductor layer so as to form a light emitting layer in which at least an n-type layer and a p-type layer are included, the n-type layer being formed on a surface side of the first nitride semiconductor layer and the p-type layer being formed on a surface side;
dividing into chips after forming a p-side electrode at a surface side thereof; and
removing a part or all of the substrate by wet etching after die bonding a side of the p-side electrode on a submount.

15. The method for manufacturing a nitride semiconductor device according to claim 14, wherein the submount is made of one selected from a group of metal, AlN, SiC and diamond, and a substance which is coated with Cu or Ag on a surface of the one.

16. The method for manufacturing a nitride semiconductor device according to claim 11, wherein the substrate is made of ZnO, and the first nitride semiconductor layer is grown on a surface of the substrate which has Zn polarity, and a back surface of the substrate which is a surface wet etched has O polarity.
